# EUROPÄISCHE PATENTSCHRIFT

(11) **EP 1 945 404 B1**
(45) Veröffentlichungstag und Bekanntmachung des Hinweises auf die Patenterteilung: **11.05.2016**
(21) Anmeldenummer: 06840921.8
(22) Anmeldetag: 20.10.2006
(51) Int. Cl.: B23K 35/36, B23K 35/362

(54) **LOTPASTEN MIT HARZFREIEN FLUSSMITTELN**
SOLDER PASTES COMPRISING NONRESINOUS FLUXES
PATES A SOUDER CONTENANT DES FLUX SANS RESINE

(30) Priorität: 08.11.2005 DE 102005053553
(43) Veröffentlichungstag der Anmeldung: 23.07.2008
(73) Patentinhaber: Heraeus Deutschland GmbH & Co. KG, 63450 Hanau (DE)
(72) Erfinder: SCHMITT, Wolfgang, 63110 Rodgau (DE); LOOSZ, Christian, 63505 Langenselbold (DE); BREER, Frank, 63875 Mespelbrunn (DE); HORNUNG, Jürgen, 63584 Gründau (DE); KREBS, Thomas, 63776 Doernsteinbach (DE); TRODLER, Joerg, 63526 Erlensee (DE)
(74) Vertreter: Heraeus IP
(86) Internationale Anmeldenummer: PCT/EP2006/010139
(87) Internationale Veröffentlichungsnummer: WO 2007/054198

(56) Entgegenhaltungen:
- DE-A1- 2 921 827
- DE-C- 841 097
- DE-C1- 4 119 012
- JP-A- 1 154 897

## Beschreibung

Die vorliegende Erfindung betrifft ein neues Gel aus einer Mischung aus Carbonsäure, Amin und Lösungsmittel, eine Paste, insbesondere Weichlotpaste, in der die metallische Komponente als Pulver in dem Gel dispergiert ist und das Aufbringen von Weichlotpasten auf UBMs (Under-Bump-Metallization) und die Anwendung dieser Weichlotpasten für Power-Module, Die-Attach, Chip-on-Board, System-in-Package (SiP), Wafer-Bumping oder SMT (Surface Mounted Technology), insbesondere lackierte Schaltungen.

DE 841 097 offenbart Lötmittel, bei denen das Amin mit der Carbonsäure zu Ureiden kondensiert wird. Gemäß DE 841 097 wird in Kauf genommen, dass Carbonsäuren und Amine in Mischungen vorliegen. Es wird aber darauf abgestellt, dass sie chemische Verbindungen mit-einander eingehen und z.B. Ureide bilden.

DE 41 19 012 beschreibt eine mit Wasser abspülbare Weichlotpaste, bestehend aus einem Weichlotpulver, einem Bindemittel-Flussmittel-Gemisch aus wasserlöslichen Salzen von Fett-Aminen mit Carbonsäure und Lösungsmittel.

JP01154897 offenbart ein Lötmittel für Stromleiterschweissung von elektronischen Bauelementen. Die Lotpaste wird produziert, indem man ein Lötmittelpulver mit einem flüssigen Flußmittel oder einem pastösen Flußmittel mischt. Tricarbonsäure mit einem Gewicht 100-300mol wird mit einem Amin wie dem Dibutylamin, dem Tributylamin und dem Diisobutylamin reagieren, welches weniger als 10% Wasser enthält. Das resultierende Produkt wird eingebunden in das Pulverflußmittel. Die Lotpaste wird für Stromleiterschweissung von elektronischen Teilen in einem gedruckten Stromkreissubstrat verwendet. Das Lötmittel hat korrosionsbeständige Eigenschaften, Alterungsbeständigkeit und hohe Zuverlässigkeit.

Es ist die Aufgabe der vorliegenden Erfindung, die Rückstandsbildung auf den Lötstellen zu minimieren.

Weiterhin sind Voids gemäß "Wafer Bumping: Is the Industry Ready?" (Greg Reed, Reed Media Services, Gurnee, III. - 10/1/2004 - Semiconductor International) nicht nur generell unerwünscht, sondern es besteht darüber hinaus der Wunsch, die maximal Void-Bildung aller Lötstellen gering zu halten. Hierzu besteht die erfindungsgemäße Aufgabe, die maximale Void-Bildung auf unter 20 Vol.-%, insbesondere unter 15 Vol.-% zu reduzieren. Weiterhin ist es wünschenswert, möglichst koplanare Bumps zu gewährleisten, weshalb sich auch eine diesbezügliche Aufgabe stellt.

Erfindungsgemäß werden Carbonsäuren und Amine mit einem polaren Lösungsmittel geliert, wobei eine Salzbildung oder eine chemische Reaktion der Carbonsäuren mit den Aminen unterdrückt wird.

Erfindungsgemäße Lösungen sind in den unabhängigen Ansprüchen beschrieben. Die abhängigen Ansprüche beschreiben bevorzugte Ausführungen.

Erfindungsgemäß wird eine harzfreie Lotpaste aus einem Metallpulver, insbesondere Weichlot und einem Gel bereitgestellt, wobei das erfindungsgemäße Gel beim Umschmelzen des Metallpulvers keine Rückstände auf der Metalloberfläche hinterlässt. Das erfindungsgemäße Gel basiert auf einer lagerstabilen Mischung aus Carbonsäure(n), Amin(en) und Lösungsmittel(n). Wichtige Anwendungen sind das Aufbringen von Weichlotpasten auf Power-Module, Die-Attachs, Chip-on-Board, SiP (System-in-Package), beim Wafer-Bumping, insbesondere auf UBMs (Under-Bump-Metallization) und SMT (Surface-Mounted-Technology), insbesondere lackierte Schaltungen. Bei Anwendung harzfreier Weichlotpasten erübrigt sich erfindungsgemäß die Reinigung vor einer Schutzlackierung nach dem Löten einer elektrischen Verbindung und wird das Ausbilden von Poren in auf UBMs-aufgebrachten Lotbumps auf unter 20 Vol.-% reduziert.

In erfindungsgemäßen Gelen sind die Carbonsäuren und Amine gelöst. Die Hauptkomponenten ergeben deshalb eine gelierte Lösung aus Aminen, Carbonsäuren und Lösungsmitteln. Die Carbonsäurekomponente besteht aus mindestens einer Carbonsäure und ist insbesondere ein Gemisch verschiedener Carbonsäuren. Die Aminkomponente besteht aus mindestens einem Amin und ist insbesondere ein Gemisch von Aminen. Die Lösungsmittelkomponente besteht aus mindestens einem Lösungsmittel, insbesondere aus einem organischen Lösungsmittelgemisch.

Zur Vermeidung von Reaktionen der Carbonsäuren mit den Aminen werden niedere Temperaturen bevorzugt, z. B. Raumtemperatur, und die Komponenten möglichst schnell miteinander gemischt. Die Gelierung erfolgt daher wohl auf Basis von Nebenvalenzen, insbesondere Wasserstoffbrücken. In der Lösung bzw. dem Gel können weitere Stoffe, wie z. B. Verdicker, dispergiert sein.

Damit wird es erfindungsgemäß ermöglicht, Flussmittelrückstände nach dem Löten von Weichlotpasten zu vermeiden. Dies wird vor allem für Anwendungen von Lotpasten, bei denen Lötstellen von den Rückständen gereinigt werden müssen, eine enorme Verfahrenserleichterung mit sich bringen. Bislang können die Kosten für die Reinigung durchaus die Kosten für die Paste übersteigen. Insbesondere werden Verfahren, bei denen sich auf den Lötprozess hin weitere Prozesse anschließen, erleichtert. Beispielsweise wird ein nachträgliches Bonden oder eine nachträgliche elektrische Prüfung mit Nadeltestem sicherer und einfacher. Für lackierte Schaltungen entfällt die bisher nötige Lackverträglichkeit mit Flussmittelrückständen.

Erfindungsgemäß werden die Verfahren auf den Gebieten Power-Module, Die-Attach, Wafer-bumping, System-in-Package, DRAM (Dynamic Random Access Memory), Automotive vereinfacht und qualitativ verbessert. Damit einhergehend wird auch die Ökobilanz verbessert, indem Ausschuss reduziert wird oder enormer Reinigungsaufwand und damit der Verbrauch von Reinigungsmitteln wegfällt.

Im Rahmen der vorliegenden Erfindung wurde erkannt, dass Harz-, insbesondere Kolophoniumbasierende Pasten beim Auftragen auf UBMs, insbesondere mit einem Rakel ihre Zusammensetzung bezüglich Metallgehalt zu Flussmittel ändern, worin die Erfinder zumindest eine Ursache für die hohe Standardabweichung bezüglich der Void-Bildung sehen und einen Zusammenhang zwischen den maximalen Voids von 30 Vol.-% und darüber und den inhomogenen Zusammensetzungen vermuten. Weiterhin ist der Feststoffgehalt bleifreier Weichlotpasten auf unter 90 Gew.-% limitiert.

Ein Lösungsansatz stellt bei der Herstellung von Wafer-Bumps darauf ab, dass das Lotpulver in einem Gel dispergiert wird. Eine Paste aus dem in dem Gel dispergierten Weichlotpulver besteht zu über 90 Gew.-% aus Weichlotpulver, insbesondere zu über 91 Gew.-%. Der Volumenanteil des Weichlotpulvers und der Paste beträgt über 55 Vol.-%, insbesondere über 60 Vol.-%.

Die Anwendung des erfindungsgemäßen Flussmittels ist nicht auf Weichlote beschränkt. Das schnell zur Paste verarbeitbare Gel eignet sich auch zur Herstellung anderer Pasten. Das erfindungsgemäße Flussmittel ist auch als Gel oder Schmiermittel verwendbar.

Erfindungsgemäß sind lagerstabile Gele herstellbar, die bei Temperaturen zwischen 150 °C und 250°C entfernbar sind. Die Lagerstabilität verleiht den Gelen oder den aus den Gelen hergestellten Pasten eine einfache Handhabung zwischen der Herstellung der Gele und deren Anwendung. Maßgeblich ist dabei, dass der Gel-Zustand über Monate hinweg erhalten bleibt. Vorzugsweise bleibt die Konsistenz des Gels während üblicher Lagerbedingungen im Wesentlichen unverändert.

Die Hauptkomponenten der Gele sind thermisch leicht entfernbare Carbonsäuren, Amine und Lösungsmittel. Diese Komponenten verflüchtigen oder zersetzen sich zwischen 150 und 250°C im Wesentlichen rückstandsfrei. Hilfsstoffe können zugesetzt werden. In untergeordnetem Maß haben sich Zusätze zur Einstellung der Rheologie bewährt. Farbstoffe werden vorzugsweise im ppm-Bereich zugesetzt. Weiterhin bewährte Zusätze sind Zersetzungsförderer wie z.B. Peroxide oder Aktivatoren wie z.B. Halogen-Aktivatoren, insbesondere Ammoniumchhlorid.

In bevorzugter Ausführung
▪ ist das Gel thermisch rückstandsfrei, oder nahezu rückstandsfrei zersetzbar,
▪ ist das Gel bezüglich Zähigkeit und Klebrigkeit harzähnlich, wie beispielsweise Kolophonium,
▪ stabilisiert das Lösungsmittel den Gelzustand,
▪ unterdrückt das Lösungsmittel chemische Reaktionen zwischen Carbonsäure und Amin,
▪ bildet das polare Lösungsmittel Wasserstoffbrücken aus,
▪ enthält das polare Lösungsmittel ein Polyol, beispielsweise Glykol oder Glycerin,
▪ werden die Carbonsäuren zum Lösen bzw. Entfernen von Metalloxiden, insbesondere Zinnoxiden auf dem Weichlotpulver verwendet,
▪ werden die Aktivatoren zum Lösen bzw. Entfernen von Metalloxiden, insbesondere Zinnoxiden auf dem Weichlotpulver verwendet,
▪ sind die Carbonsäuren leicht zersetzbar,
▪ sind die Carbonsäuren mehrfunktionell, wie beispielsweise Zitronensäure, Adiphinsäure, Zimtsäure und Benzylsäure,
▪ weisen die Carbonsäuren 2 bis 50 C-Atome und bis zu zwei aromatische Ringe auf,
▪ sind die Amine tertiär,
▪ weisen die Amine 6 bis 100 C-Atome auf,
▪ ist der Gewichtsanteil der Carbonsäure höher als der Gewichtsanteil des Amins.

Erfindungsgemäß lassen sich harzfreie Lotpasten bereitstellen. Harzrückstände können erfindungsgemäß somit eliminiert werden. Das erfindungsgemäße Matrixmaterial für das Lotpulver ist im Wesentlichen thermisch abbaubar.
Das Gel kann mit 1 bis 5 Gew.-% Verdicker bezüglich seiner Konsistenz eingestellt werden. Bevorzugte Verdicker sind ebenfalls thermisch abbaubar. Wird als Verdicker ein nicht vollständig abbaubares Wachs verwendet, lassen sich dennoch weitgehend rückstandsfreie Lotpasten bereitstellen, deren Rückstände auf weniger als 1 Gew.-% einstellbar sind. Als Verdicker eignen sich auch Polyamide oder amorphe Kieselsäure. Amorphe Kieselsäure scheidet sich beim Lötvorgang lose an der Oberfläche, der Lötstelle ab. Dabei bleiben Spuren von Verunreinigungen an der Kieselsäure haften, und lassen sich mit dieser ohne Verwendung von Lösungsmitteln einfach wegpolieren.

Zur Weiterverarbeitung des Gels zur Weichlotpaste werden in etwa gleiche Volumina Gel und Metallpulver vermischt. Dabei haben sich besonders feinpulvrige Metallpulver und bi- oder mehrmodale Metallpulver bewährt, insbesondere für Anwendungen ohne zusätzlichen Verdicker. Die vorliegende Erfindung ermöglicht es nun, das Metallpulver direkt im Anschluss an die Herstellung des Gels im Gel zu dispergieren. Die bislang übliche Wartezeit vor dem Einbringen des Metallpulvers in das Flussmittel entfällt.

Bewährt haben sich Lotpasten aus 40 bis 60 Volumen-% Flussmitteln und 40 bis 60 Vol.-% Weichlotpulver.

In erfinderischer Weiterbildung wird dem Gel ein Farbstoff zugesetzt. Bewährt haben sich Pasten mit 10 bis 200 ppm Phtalocyanine. Das entspricht 0,1 bis 2 ‰ Phtalocyanin im Flussmittel bzw. Gel. Bevorzugt sind die Farbstoffe in Metallen unlöslich und zersetzen sich in Abwesenheit einer organischen Matrix. Die Phtalocyanine genügen diesen Anforderungen hinreichend. Auch Fluoreszenzfarbstoffe sind sehr geeignet. Beispielsweise können mit 1 ppm Fluoreszenz-Farbstoff in einer Paste verbleibende Rückstände der Paste visualisiert werden. Besonders geeignet sind Fluoreszenz-Farbstoffe, die von der Gelmatrix stabilisiert werden und ohne Stabilisierung sich thermisch zersetzen. Auf diese Weise lassen sich geringste Rückstände anzeigen. Damit ist zum einen die Qualität kontrollierbar und es wird zum anderen ermöglicht, noch geringste Rückstände gezielt zu beseitigen. Bewährt haben sich Farbstoffe oder Fluoreszenz-Pigmente mit Zersetzungstemperaturen zwischen 150 und 250°C.

Besonders wertvoll ist die vorliegende Erfindung für alle Anwendungen, die bislang nach dem Lötprozess eine Reinigung erfordern. Hervorgehoben seien die Anwendungen von Lotpasten in den Bereichen Power-Module, Die-Attach oder Chip-on-Board. In diesen Anwendungen folgt nach dem Anlöten eines Bauteils zur mechanischen Befestigung ein Bondprozess zur elektrischen Kontaktierung. Rückstände, die vom Umschmelzprozess der Lotpaste auf den Bondflächen ablagern, machen ein Bonden unmöglich oder erschweren dies zumindest erheblich. Es ist daher wichtig für den Bondprozess, dass keine Flussmittelrückstände auf den Bondflächen vorhanden sind. Erfindungsgemäß wird nun ein Bondprozess ohne vorgelagerten Reinigungsprozess ermöglicht.

Eine weitere wichtige Anwendung erfindungsgemäßer Gele und entsprechender Weichlotpasten betrifft das Lackieren von Schaltungen. Schutzlacke bezwecken neben ihrer Schutzfunktion vor Umwelteinflüssen der elektrischen Isolation. Die bislang erforderlichen Verträglichkeiten von Lack und Rückständen entfallen bei den erfindungsgemäßen rückstandsfreien oder rückstandsarmen Lotpasten.

Für das Aufbringen von Weichlotpasten auf UBMs (Under-Bump-Metallization) basiert das der Weichlotpaste zugrundeliegende Gel vorzugsweise auf einer polaren Lösungsmittelkomponente, insbesondere einem wasserlöslichen Lösungsmittel und einem Verdicker auf Basis einer Amin-oder Carbonsäurekomponente.

Vorzugsweise beträgt der Anteil der Weichlotpaste an Hilfsstoff (geliertem Lösungsmittel) 5 - 40 Vol-%. Bewährt haben sich hierfür polare Lösungsmittel wie Glycerin, Glykol, Tridekanol, Terpineol. Eine Vielzahl von Polyolen ist für die Zwecke als Lösungsmittel aufgrund ihrer guten Trageeigenschaften und hohen Viskosität für die Anwendung als Lösungsmittel gemäß der vorliegenden Erfindung geeignet. Weitere von der Fettherstellung her bekannte polare Lösemittel mit hoher Viskosität und gutem Trageverhalten sind ebenfalls als Lösungsmittel für die Zwecke der vorliegenden Erfindung anwendbar. Dabei lassen sich die rheologischen Eigenschaften des Lösungsmittels durch Mischen verschiedener Lösungsmittel einstellen. Die Viskosität der Lösungsmittel ist aber im Vergleich zur Viskosität von Harzen, wie beispielsweise Kolophonium, deutlich geringer, so dass bezüglich Pasten mit vergleichbarem Metallpulver eine Absenkung der Viskosität gegenüber harzigem Flussmittel aufweisenden Pasten bereitgestellt wird. Bei gleicher Viskosität ist der Weichlotpulveranteil der Paste gegenüber den Pasten mit harzigem Flussmittel erhöht. Während bei Pasten mit harzigem Flussmittel der Anteil des Weichlotpulvers zwischen 87 und 88,5 Gew.-% beträgt und ein Auftrag mit 90 Gew.-% auf einem Wafer mit Photoresist an der zu hohen Viskosität der Paste scheitern würde, wird erfindungsgemäß ein Weichlotpulveranteil von über 90 Gew.-%, insbesondere über 91 Gew.-% durch Pasten, deren Flussmittel auf einem polaren Lösungsmittel basiert, erreicht, insbesondere durch Gelierung mit polaren Lösungsmitteln.
Die Carbonsäurekomponente hat die Funktion, Oxidhäute auf den zu verlötenden Metalloberflächen zu lösen. Es ist daher darauf zu achten, dass die metalloxidlösende Funktion der Carbonsäurekomponente durch die Anwesenheit der weiteren Pastenkomponenten nicht wesentlich abgebaut wird. Insbesondere sind Reaktionen mit der Aminkomponente zu Salzen oder Carbonsäureamiden zu vermeiden. Die Amin-Komponente hat eine Aktivierungsfunktion, wobei darauf zu achten ist, dass diese Aktivierungsfunktion nicht durch Reaktion mit weiteren Komponenten der Weichlotpaste, insbesondere deren Carbonsäurekomponente verloren geht.

Alle bekannten Weichlotpulver sind erfindungsgemäß anwendbar, beispielsweise auf Basis von Zinn, Blei, Wismut, Indium, Gold oder Silber.

Das Weichlotpulver enthält vorzugsweise Zinn, insbesondere über 50 Gew.-% und ggf. über 90 Gew.-%. Silber und Kupfer sind geeignete Legierungsbestandteile. Die klassischen Zinn-Blei-Lote sowie hochbleihaltige Lote sind ebenfalls erfindungsgemäß anwendbar.

Bevorzugt werden Pulvertypen kleiner 38 µm, insbesondere kleiner 25 µm, entsprechend dem Typ 4, 5, 6 und kleiner gemäß ANSI/J-STD-005 oder DIN/EN 61190.

Eine damit einhergehende Anwendungslösung besteht in einer Vielzahl von UBMs, die mit Weichlotpaste beschichtet sind, wobei die Weichlotpaste je UBM 60 - 90 Vol-% Weichlotpulver, 1.0 - 40 Vol-% polares Lösungsmittel, 0 - 20 Vol-% tertiäres Amin und 0 - 20 Vol.-% Carbonsäure aufweist. In bevorzugten Ausführungen beträgt
▪ das Weichlotpulver über 70 Vol.-%;
▪ die Summe der Volumen der Aminkomponente und der Carbonsäurekomponente 10 - 20 Vol-%;
▪ das polare Lösungsmittel 20 - 30 Vol.-%.

Insbesondere ist das polare Lösungsmittel der Hauptbestandteil des Flussmittels, also des der Paste zugrundeliegenden Gels. Erfindungsgemäß wird die Void-Bildung durch den Auftrag der Weichlotpaste zum einen durch den hohen Volumenanteil des Weichlotpulvers an der Paste und die im Wesentlichen konstant bleibende Zusammensetzung der Paste beim Auftrag über die Vielzahl von Lot-Depots insbesondere auf UBMs gewährleistet. Die Homogenität in der Konstanz der Zusammensetzung bleibt unter den üblichen Bearbeitungsbedingungen im Wesentlichen so erhalten, dass nach dem Umschmelzen der Weichlotpaste in einem Vertrauensbereich von 3 Sigma, insbesondere 4 Sigma, die entstehenden Voids auf maximal 20 Vol.-% begrenzt werden, vorzugsweise auf maximal 15 Vol.-%.

Es wird angenommen, dass die guten Trageeigenschaften und die hohe Viskosität des Lösungsmittels sich vorteilhaft auf die Stabilität von Pasten mit hohem Weichlotpulvergehalt auswirken. Überraschenderweise wird mit den polaren Lösungsmitteln eine Reaktion zwischen der Aminkomponente und der Carbonsäurekomponente vermieden, so dass die erfindungsgemäß anwendbare Weichlotpaste lagerstabil ist. Vorzugsweise enthält die Lotpaste nur geringfügige oder am besten überhaupt keine Reaktionsprodukte der Carbonsäure mit dem Amin.

Weiter vorzugsweise besteht die Paste aus einem Gel, in dem das Weichlotpulver dispergiert ist, insbesondere aus einem harzarmen oder harzfreien Gel. Beim Verteilen einer ein Gel als Flussmittel aufweisenden Paste mit einem Rakel bleibt die Zusammensetzung der Paste im Unterschied zu Pasten mit harzigem Flussmittel konstant und es erfolgt bei gleichmäßigem Auftrag der Paste eine gleichmäßige Lotpulververteilung über die Vielzahl der UBMs. Dies ermöglicht das Bereitstellen besonders koplanarer Bumps und reduziert die Bildung großer Voids.

UBMs sind metallische, nicht zusammenhängende Anschlussflächen auf der Waferoberfläche, die für eine Beschichtung u.a. mit Lot vorgesehen sind. Auf einer Waferscheibe ist eine Vielzahl von UBMs angeordnet, wovon nach der Vereinzelung der Waferscheibe in Chips die auf den UBMs angeordneten Lote für den bestimmungsgemäßen Anschluss der Chips vorgesehen sind. Ein bevorzugtes Verfahren zum Aufbringen der Weichlotpaste auf UBMs besteht darin, dass die Lotpaste mittels Drucktechnologie, insbesondere mit einer Rakel, auf Photoresist oder mittels einer Schablone aufgetragen wird. Ein weiteres Verfahren besteht im berührungslosen Aufbringen der Weichlotpaste auf die UBMs mit einem geeigneten Dispenser, beispielsweise in Jet-Technologie.

Nachfolgend wird die Erfindung anhand von Beispielen mit Bezug auf die Zeichnungen verdeutlicht.
- Figur 1: zeigt Lötstellen, bei denen geringste Rückstände durch Farbstoff sichtbar gemacht werden, Fig. 1a ohne Farbstoff, Fig. 1b mit Phthalocyanin, Fig. 1c ohne Fluoreszenz-Farbstoff und Fig. 1d mit Fluoreszenz-Farbstoff;
- Figur 2: zeigt in Fig. 2a ein Power-Modul und in Fig. 2b und 2c in einem vergrößerten Ausschnitt dazugehörige Bondflächen, wobei im Vergleichsbeispiel von Fig. 2c Bondflächen verschmutzt sind;
- Figur 3: zeigt lackierte Schaltungen;
- Figur 4: zeigt ein Die-Attach-Schema, aus dem der Träger, auf dem der Chip befestigt wird, vergrößert ist;
- Figur 5: zeigt eine Speicherkarte, aus der ein Teil der Kontaktleiste vergrößert ist;
- Figur 6: zeigt ein Histogramm eines Wafers nach dem Umschmelzen der zwischen Photoresist auf UBMs aufgetragenen Weichlotpaste gemäß Tabelle 1;
- Figur 7: ist eine alternative Darstellung des Ergebnisses aus Tabelle 1 als Scatterplot (Streudiagramm);
- Figur 8: ist eine weitere alternative Darstellung des Ergebnisses aus Tabelle 1 als Box-and-Whisker-Ptot;
- Figuren 9 bis 12: zeigen Vergleichsbeispiele zu Figur 6 und Figur 8 gemäß Tabellen 2 und 3.

### Beispiel 1

In einem Behältnis werden 67 Gew.-% Tridecanol, 20 Gew.-% Zimtsäure, 10 Gew.-% einer tertiären C16-Aminfraktion und 3 % Wachs bei Raumtemperatur gerührt, bis ein gelartiger Zustand erreicht ist. Danach wird das Gel mit Lotpulver zu einer Lotpaste nach den gängigen Verfahren weiterverarbeitet. Das Gel erfordert keine weitere Standzeit vor der Verarbeitung mit dem Lotpulver.

### Beispiel 2

In einem Behältnis werden 67 Gew.-% Tridecanol, 20 Gew.-% Zimtsäure, 10 Gew.-% einer tertiären C16-Alkylaminfraktion, 3 % Rizinusester und 0,01 Gew.% Phthalocyanine (Hostatint Grün GG 30) bei Raumtemperatur gerührt, bis ein gelartiger Zustand erreicht ist. Danach wird das Gel mit Lotpulver zu einer Lotpaste nach den gängigen Verfahren weiterverarbeitet. Das Gel erfordert keine weitere Standzeit vor der Verarbeitung mit dem Lotpulver.

### Beispiel 3

In einem Behältnis werden 53 Gew.-% Tridecanol, 14 Gew.-% Terpineol, 10 Gew.-% einer tertiären C12-Alkylaminfraktion, 20 Gew.-% Sebacinsäure und 3 % Rizinusester bei Raumtemperatur gerührt, bis ein gelartiger Zustand erreicht ist. Danach wird das Gel mit Lotpulver zu einer Lotpaste nach den gängigen Verfahren weiterverarbeitet. Das Gel erfordert keine weitere Standzeit vor der Verarbeitung mit dem Lotpulver.

### Beispiel 4

In einem Behältnis werden 67 Gew.-% Glycerin, 7 Gew.-% Zimtsäure, 18 Gew.-% einer tertiären C18-Alkylaminfraktion, 5 Gew.-% Adipinsäure, 3 % Rizinusester und 10 ppm Fluoreszenz-Farbstoff (Fluoreszenz-Pigment Z-17-N der Firma Dayglo) bei Raumtemperatur gerührt, bis ein gelartiger Zustand erreicht ist. Danach wird das Gel mit Lotpulver zu einer Lotpaste nach den gängigen Verfahren weiterverarbeitet. Das Gel erfordert keine weitere Standzeit vor der Verarbeitung mit dem Lotpulver.

### Beispiel 5

In einem Behältnis werden 25,5 Gew.-% Tridecanol, 25 Gew.-% Terpineol, 10 Gew.-% tertiäres Alkylamin (C18 Fraktion), 30 Gew.-% Sebacinsäure, 8 Gew.-% Benzilsäure und 1,5 Gew.-% Adipinsäure bei Raumtemperatur gerührt, bis ein gelartiger Zustand erreicht ist. Danach wird das Gel ohne weitere Wartezeit mit 90,5 Gew.-% Lotpulver Sn63Pb37 mit einem Komgrößenbereich von 5 bis 15 µm zu einer Lotpaste nach den gängigen Verfahren weiterverarbeitet. Die gesamte Pastenherstellung erfolgt innerhalb von 20 Minuten. Auf diese Weise kann eine hervorragende Paste ohne weiteren Verdicker erzielt werden. Rückstände konnten nicht festgestellt werden und liegen zumindest unter 0,1 Gew.-%.

### Beispiel 6

In einem Behältnis werden 37,5 Gew.-% Tridecanol, 28 Gew.-% Terpineol, 10 Gew.-% 2-Ethyl-4-menthylimidazol, 15 Gew.-% Sebacinsäure, 8 Gew.% Benzilsäure und 1,5 Gew.-% Adipinsäure bei Raumtemperatur gerührt, bis ein gelartiger Zustand erreicht ist. Auf diese Weise kann eine hervorragende Gelbildung ohne weiteren Verdicker erzielt werden. Danach wird das Gel mit Lotpulver zu einer Lotpaste nach den gängigen Verfahren weiterverarbeitet. Das Gel erfordert keine weitere Standzeit vor der Verarbeitung mit dem Lotpulver und ist innerhalb von 20 Minuten verbrauchsfertig hergestellt. Rückstände nach dessen Umschmelzvorgang konnten nicht festgestellt werden und liegen zumindest unter 0,1 Gew.-%.

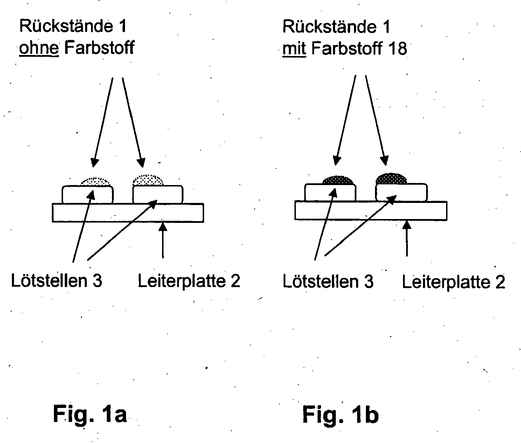

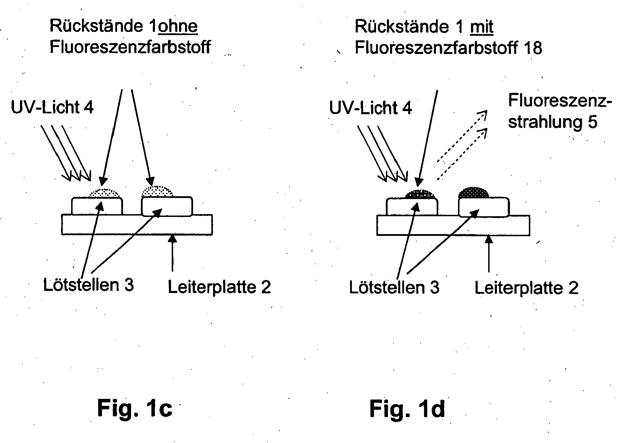

Figur 1a und 1c zeigen Rückstände 1 auf einer Leiterplatte 2 angeordneten Lötstellen 3. Figuren 1b und 1d zeigen Lötstellen eingefärbter Flussmittel, bei denen die Farbstoffe 18 nur im Rückstand stabil sind. Die nach einem der Beispiele 1 bis 6 hergestellten Gele werden jeweils mit gleichem Volumen an Lotpulver zu einer Lotpaste gemischt. Nach bestimmungsgemäßer Anwendung der Lotpasten betrug der Rückstand 1 jeweils weniger als 1 Gew.-%. Die Rückstände 1 von Pasten nach Beispiel 2 sind in Figur 1b verdeutlicht. Die Rückstände 1 von Pasten nach Beispiel 4 sind in Figur 1d verdeutlicht. In Figur 1d ist eine Abbildung einer Lötstelle abstrahiert, wobei durch UV-Anwendung 4 eine Fluoreszenz 5 initiiert wird, die eine verbesserte Erkennung gegenüber Figur 1c verdeutlicht. Dies ermöglicht eine automatische Detektierung äußerst geringer Rückstände 1. Der Bonder kann dann so gesteuert werden, dass der Bonddraht nur auf saubere Flächen angesetzt und gebondet wird.

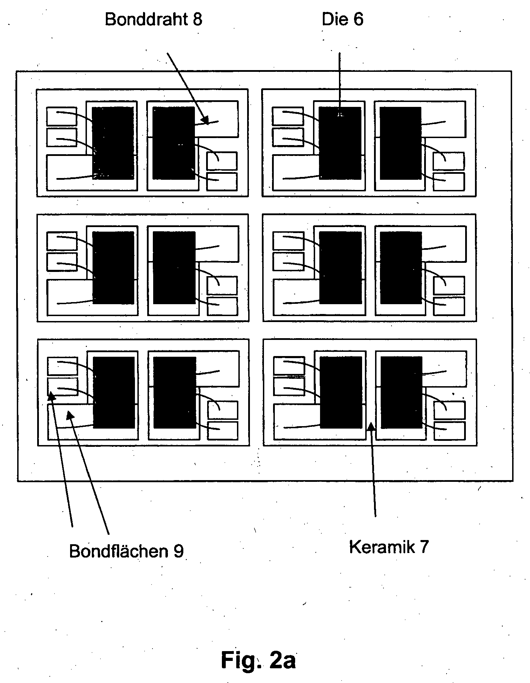

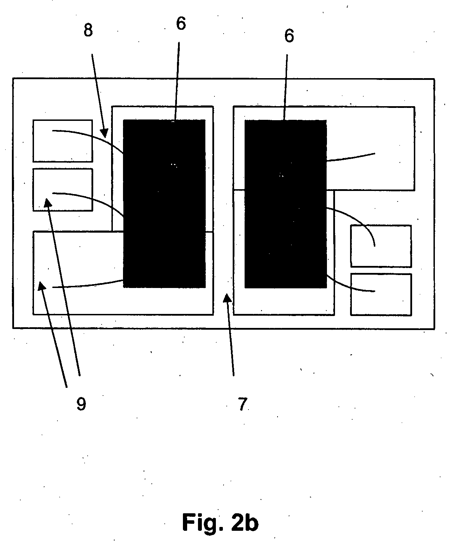

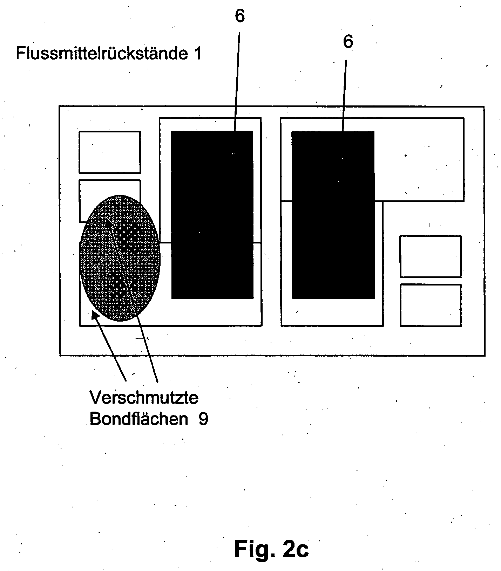

Figur 2a zeigt ein Power-Modul, bei dem auf einer Keramikplatte 7 mehrere Dies 6 über Bonddrähte 8 mit Bondflächen 9 verbunden sind. Figur 2b zeigt die vergrößerten Bondflächen eines Power-Moduls, die bei bestimmungsgemäßer Anwendung einer nach einem der Beispiele 1 bis 5 hergestellten Paste bei der Befestigung eines Bauteils nicht durch Rückstände 1 aus der Lotpaste verunreinigt werden (Fig. 2c), wie dies bei den bekannten Lotpasten gemäß Figur 2c der Fall ist. Deshalb lassen sich die Bauteile nach ihrer Befestigung bonden, ohne dass eine Reinigung der Bondflächen erfolgt, weil erfindungsgemäß Lotpastenreste vermeidbar sind und die Bondflächen deshalb erfindungsgemäß nicht verunreinigt werden.

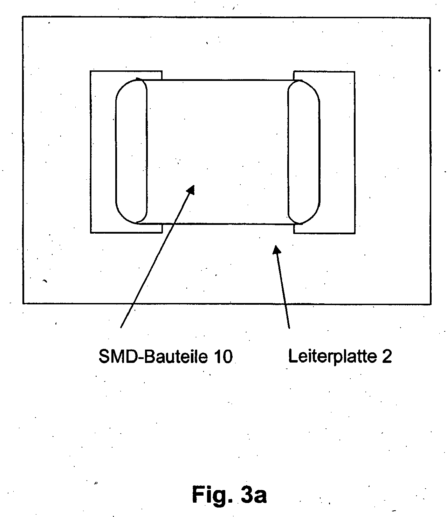

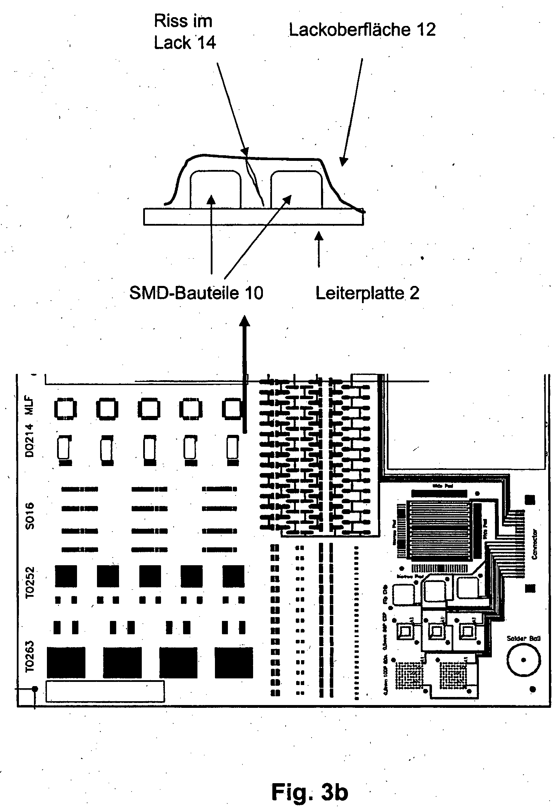

Fig. 3 zeigt lackierte Schaltungen.

Fig. 3a zeigt eine erfindungsgemäße Schaltung, bei der die gelötete Komponente vergrößert ist und im Bereich der gelöteten Komponente keine Rückstände ersichtlich sind.

Figur 3b zeigt eine lackierte Schaltung, aus der SMD-Bauteile 10 vergrößert sind und die zwischen den Bauteilen 10 befindliche Lackierung 12 einen Riss 14 aufweist, der von Lotrückständen im Stand der Technik verursacht wurde.

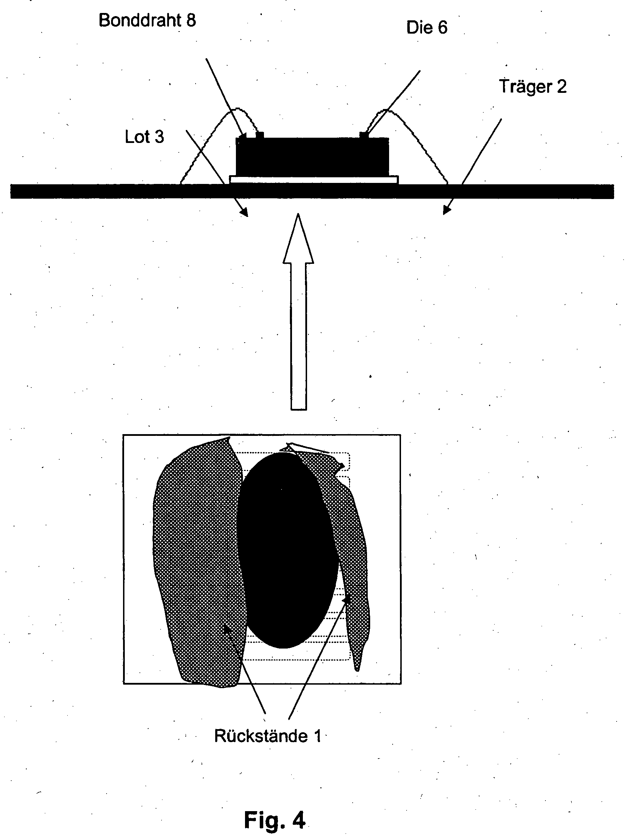

Fig. 4 zeigt eine Lötstelle 3 unterhalb eines Die (ungehäustes aktives elektrisches Bauelement) 6, deren Ort durch den Pfeil angedeutet ist. Die Lötstelle 3 ist durch Flussmittelrückstände 1 verschmutzt und muss für Bondungszwecke zunächst gereinigt werden. Durch Einsatz der erfindungsgemäßen Pasten kann die Verschmutzung im Wesentlichen abgestellt werden, so dass eine Reinigung überflüssig wird. Dies ermöglicht eine enorme Vereinfachung des Verfahrens. Der bislang für die Reinigung entstandene Aufwand verursacht höhere Kosten, als für die Lötpaste aufgewendet werden.

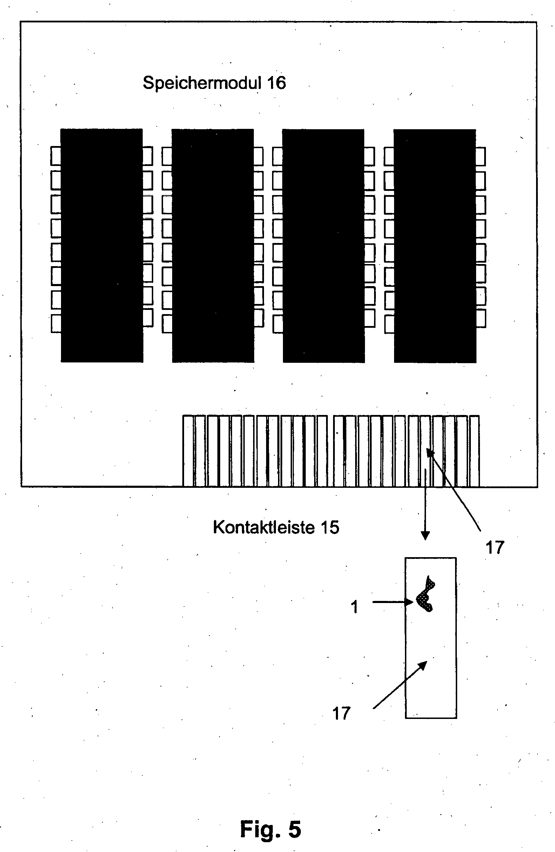

Fig. 5 zeigt die Vergrößerung einer Kontaktfläche 17 aus einer Kontaktleiste 15 eines Speichermoduls 16. Beim Löten von Bauteilen auf die Leiterplatte spritzt Flussmittel bis auf die Leiste 15 und verunreinigt die Kontaktflächen 17. Dies führt zu einer ungenügenden Kontaktierung beim Einstecken des Moduls in den Hauptschaltungsträger (Main Board). Erfindungsgemäß werden selbst beim Verspritzen der Flussmittel keine Rückstände auf den Kontakten festgestellt, da die erfindungsgemäßen Flussmittel sich nahezu rückstandsfrei zersetzen. Dadurch wird die Effizienz bei der Herstellung von Speichermodulen erheblich verbessert.

Zur Herstellung einer harz- und bleifreien Weichlotpaste wird ein Gel als Flussmittel vorbereitet. Zur Herstellung des Gels werden 53 Gew.-% Tridecanol, 14 Gew.-% Terpineol, 10 Gew.-% einer tertiären C12-Alkylaminfraktion, 20 Gew.-% Sebacinsäure und 3 % Rizinusester bei Raumtemperatur gerührt, bis ein gelartiger Zustand erreicht ist. Dieses Gel wird im Gewichtsverhältnis 8,5 : 91,5 mit einem (SA₄C_{0,5}) Zinn-Silber-Kupfer-Weichlotpulver (95,5 Gew.-% Zinn, 4 Gew.-% Silber, 0,5 Gew.-% Kupfer) der Typklasse 5 (15 - 25 µm) gemischt.

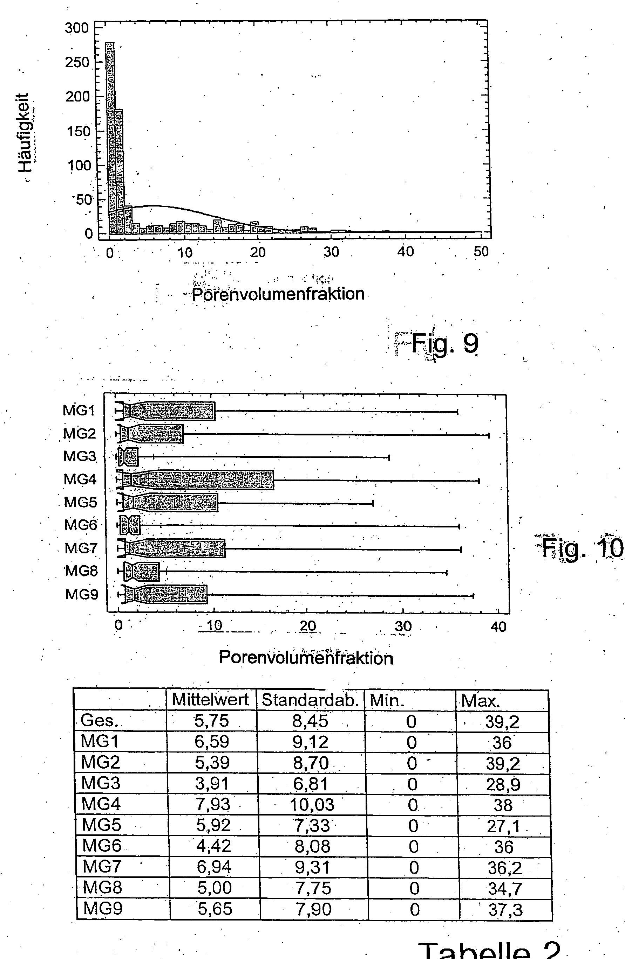

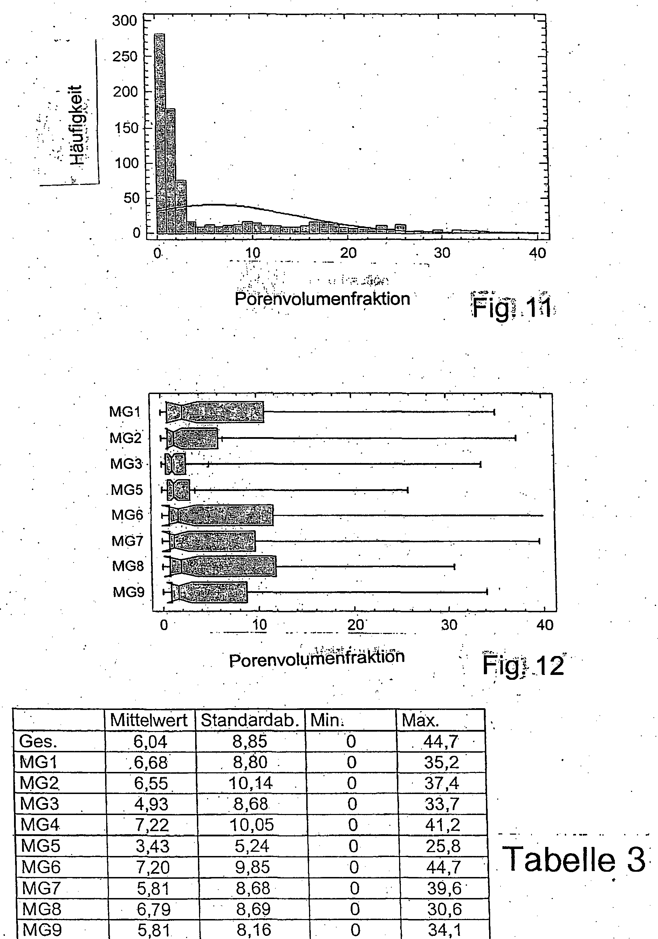

Eine so zusammengesetzte Paste wird auf einem Wafer mit Photoresist mit einer Rakel aus Hartgummi auf die UBMs des Wafers aufgetragen. Alternativ ist ein Auftrag mittels Schablone oder Sieb auf die UBMs eines Wafers geeignet. Nach dem Umschmelzen der auf die UBMs aufgetragenen Weichlotpaste wird der Wafer hinsichtlich der Porenbildung (Voids) der Bumps und der Koplanarität bezüglich der Bumphöhen analysiert. Die Messergebnisse der Voids-Analyse sind in Tabelle 1 zusammengefasst. Der Wafer wurde in 9 Regionen zu je 380 Bumps eingeteilt und ausgewertet. Die maximalen Voids betrugen 13,6 Vol.-%, also noch deutlich unter 15 Vol-%. Die maximale Standardabweichung beträgt 2,54 und untermauert damit die gleichmäßige Ausbildung von Voids mit einem Mittelwert deutlich unter 5 Vol.-%. Die enge Verteilung schließt aufgrund statistischer Wahrscheinlichkeit Voids über 20 Vol.-% praktisch aus und erst recht Voids über 30 Vol.-%. Zum Vergleich wurde ein Wafer mit konventioneller Paste, d.h. mit einem auf Kolophonium basierenden Flussmittel und 89 Gew.-% Weichlotpaste hergestellt. Die damit erzielten Ergebnisse sind Tabelle 2 entnehmbar. Figuren 9 und 10 visualisieren diese Ergebnisse. Ein Auftrag mit 90 Gew.-% Weichlotanteil an der Paste konnte mit dem Rakel nicht mehr brauchbar auf den Photoresist aufgetragen werden, da die Viskosität der Paste zu hoch war. In einem weiteren Vergleichsbeispiel betrug der Weichlotanteil der Paste mit Kolophonium basierenden Flussmittel 88 Gew.-%. Die entsprechenden Ergebnisse sind in Tabelle 3 zusammengefasst. Figuren 11 und 12 visualisieren diese Ergebnisse.

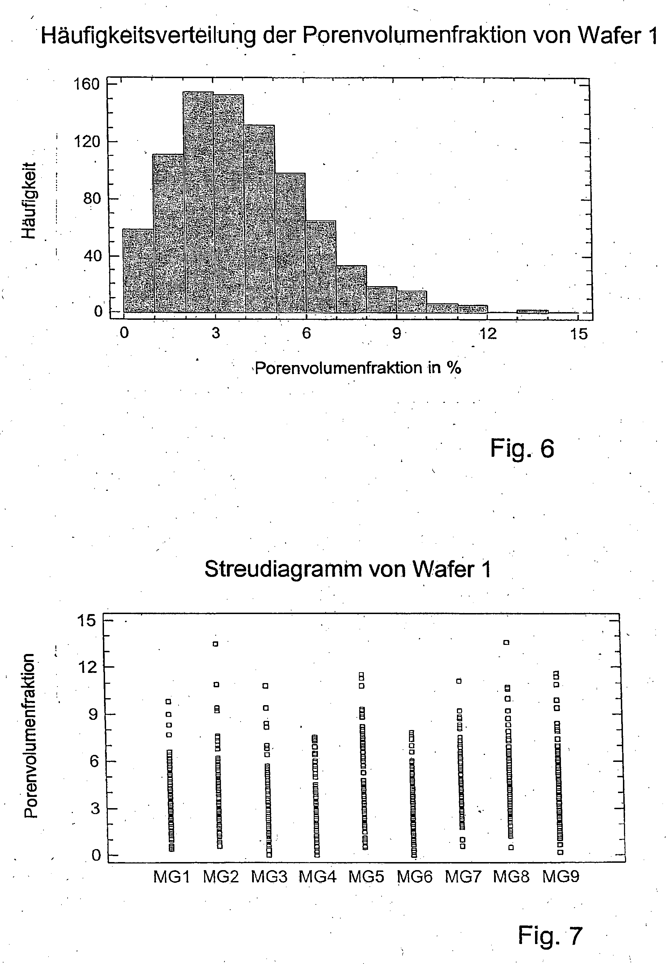

Abbildungen 6, 9 und 11 zeigen die Häufigkeit der Void-Klassen mit einer Breite von 1 Vol.-%. Der erfindungsgemäße Auftrag gemäß Figur 1 und 6 zeigt ein kompaktes Maximum um die Klassen 2 bis 3 und 3 bis 4 Vol.-%, denen gegenüber die Klassen 5 bis 6 oder 6 bis 7 und erst recht 7 bis 8 Vol.-% einen starken Abfall verzeichnen. Der Anteil über 10 Vol.-% ist bereits äußerst gering und auf unter 15 Vol.-% beschränkt. Dagegen zeigt das Vergleichsbeispiel nach Figur 9 ein Maximum an Voids für die Klassen 0 bis 1 und 1 bis 2 Vol.-% und sinkt ab der Void-Klasse 3 bis 4 Vol.-% auf zwar kleine Werte, die aber bis zur Klasse 28 bis 29 Vol.-% nur noch schwach abfallen. Äußerst problematisch sind die noch verbliebenen Voids in den Klassen mit über 30 Vol.-%. Das zweite Vergleichsbeispiel zeigt in Figur 11 einen ähnlichen Vergleich wie das erste Vergleichsbeispiel in Figur 9.

Das Streudiagramm (Scatterplot) aus Figur 7 verdeutlicht die erfindungsgemäßen Ergebnisse aus Tabelle 1 durch die Häufung der jeweils 380 Messpunkte in den Messgruppen 1 bis 9 des Wafers. Hier ist ersichtlich, dass die Voidsbildung zwischen 6 und 10 Vol.-% deutlich ausdünnt und nur noch vereinzelte Ausreißer zwischen 10 und 15 Vol.-% auftreten. Dies zeigt, dass erfindungsgemäß Voids oberhalb von 15 Vol.-% praktisch ausgeschlossen werden und dass erst recht mit Voids oberhalb von 20 Vol.-% nicht zu rechnen ist und schon gar nicht mit Voids oberhalb von 25 Vol.-%.

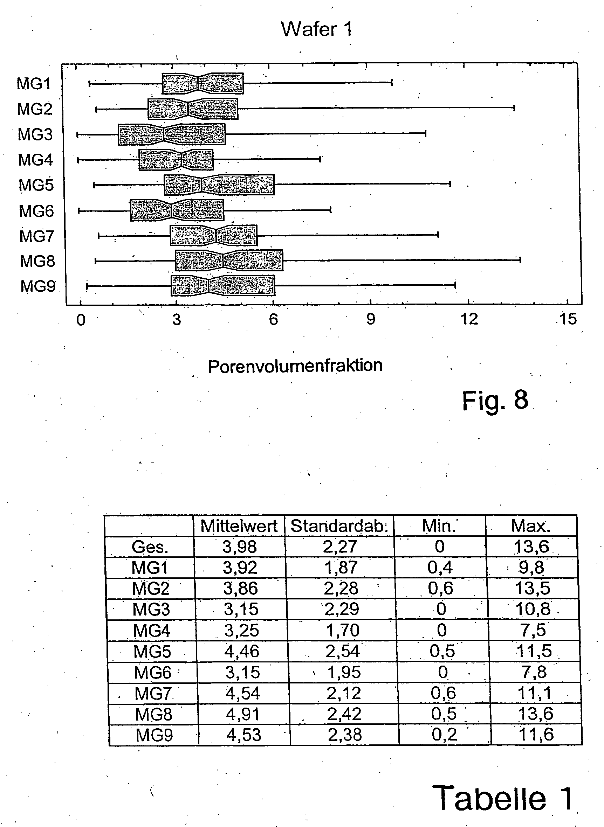

In dem Box-and-Whisker-Plot nach Figur 8, 10 und 12 wird die Spanne der Voids durch die Linie pro Messgruppe verdeutlicht. Das Kreuz zeigt den Mittelwert (Durchschnitt). Die Einkerbung gibt den Median an, d.h. den mittleren Wert der gemessenen Werte. Die Balken zeigen die Standardabweichung Sigma des Medianwertes in die beiden Messwertrichtungen.

## Patentansprüche

1. Lagerstabiles Gel enthaltend als Hauptkomponenten eine Carbonsäurekomponente, eine Aminkomponente und eine Lösungsmittelkomponente wobei die Carbonsäurekomponente eine thermisch leicht entfernbare Substanz aus einer Carbonsäure oder einem Carbonsäuregemisch ist, die Aminkomponente eine thermisch leicht entfembare Substanz aus einem tertiären Amin oder eine Mischung tertiärer Amine ist, und die Lösungsmittelkomponente ein polares Lösungsmittel oder eine Mischung polarer Lösungsmittel ist, **dadurch gekennzeichnet, dass** das Gel harzfrei ist.

2. Gel nach Anspruch 1, **dadurch gekennzeichnet, dass** die Lösungsmittelkomponente Wasserstoffbrückenbildner aufweist.

3. Verfahren zur Herstellung eines harzfreien Gels, **dadurch gekennzeichnet, dass** eine Carbonsäurekomponente, eine Aminkomponente und eine Lösungsmittelkomponente miteinander geliert werden wobei die Carbonsäurekomponente eine thermisch leicht entfernbare Substanz aus einer Carbonsäure oder einem Carbonsäuregemisch ist, die Aminkomponente eine thermisch leicht entfembare Substanz aus einem tertiären Amin oder eine Mischung tertiärer Amine ist, und die Lösungsmittelkomponente ein polares Lösungsmittel oder eine Mischung polarer Lösungsmittel ist.

4. Verfahren zur Herstellung einer harzfreien Paste, **dadurch gekennzeichnet, dass** ein Gel nach
einem der Ansprüche 1 bis 3 mit einem Feststoffpulver dispergiert wird.

5. Lotpaste, bei der ein Weichlotpulver in einem Gel, insbesondere einem Gel nach einem der Ansprüche 1 bis 3 dispergiert wird, wobei das Gel im wesentlichen eine Karbonsäurekomponente und eine Aminkomponente aufweist,
die in einem polaren Lösungsmittel geliert sind, **dadurch gekennzeichnet, dass** die Lotpaste harzfrei ist.

6. Lotpaste nach Anspruch 5, **dadurch gekennzeichnet, dass** die Lotpaste Farbstoff aufweist, insbesondere weniger als 1 Gew.-‰.

7. Verfahren zum Anlöten von Bauteilen und anschließendem Bonden, **dadurch gekennzeichnet, dass** eine harzfreie Lötpaste zur Befestigung eines Bauteils umgeschmolzen wird und das Bauteil ohne weitere Reinigung der Bondflächen mit oberflächenaktiven
oder basischen Substanzen danach gebondet wird.

8. Verwendung einer harzfreien Lotpaste nach einem der Ansprüche 4 bis 6 für das Aufbringen von Weichlotpasten für Power-Module, Die-Attach, Chip-on-Board, System-in-Package (SiP), Wafer-Bumping, insbesondere auf UBMs (Under-Bump-Metallization) oder SMT (Surface Mounted Technology), insbesondere lackierte Schaltungen.

9. Verwendung einer harzfreien Lotpaste insbesondere nach einem der Ansprüche 4 bis 6 für den Aufbau von elektrischen Verbindungen, die nach dem Löten ohne Nachbehandlung zum Entfernen von Flussmittelresten mit Polymeren beschichtet, insbesondere mit einem Schutzlack versehen werden.

10. Verwendung einer harzfreien Lotpaste insbesondere nach einem der Ansprüche 4 bis 6 für den Aufbau von Lotbumps auf Wafern, **dadurch gekennzeichnet, dass** das Ausbilden von Poren auf unter 20 Vol.-% des Bump-Volumens mit der harzfreien Lotpaste erzielt wird.

## Claims

1. A gel, that is stable during storage and contains, as main components, a carboxylic acid component, an amine component and a solvent component, whereby the carboxylic acid component is a substance made of a carboxylic acid or a carboxylic acid mixture that is easy to remove by thermal means, the amine component is a substance made of a tertiary amine or a mixture of tertiary amines that is easy to remove by thermal means, and the solvent component is a polar solvent or a mixture of polar solvents, **characterised in that** the gel is free of resin.

2. Gel according to claim 1, **characterised in that** the solvent component comprises hydrogen bond-forming agents.

3. Method for producing a resin-free gel, **characterised in that** a carboxylic acid component, an amine component and a solvent component are gelled together, whereby the carboxylic acid component is a substance made of a carboxylic acid or a carboxylic acid mixture that is easy to remove by thermal means, the amine component is a substance made of a tertiary amine or a mixture of tertiary amines that is easy to remove by thermal means, and the solvent component is a polar solvent or a mixture of polar solvents.

4. Method for producing a resin-free paste, **characterised in that** a gel according to any one of the claims 1 to 3 is dispersed together with a powder of a solid.

5. Soldering paste, in which a soft solder powder is dispersed in a gel, in particular a gel according to any one of the claims 1 to 3, whereby the gel essentially comprises a carboxylic acid component and an amine component that are gelled in a polar solvent, **characterised in that** the soldering paste is free of resin.

6. Soldering paste according to claim 5, **characterized in that** the soldering paste comprises colorant, in particular less than 1‰ by weight.

7. Method for attaching, by soldering, components and subsequent bonding, **characterised in that** a resin-free soldering paste is re-melted for attachment of a component and **in that** the component is then being bonded without further cleaning of the bond surfaces with surface-active or basic substances.

8. Use of a resin-free soldering paste according to any one of the claims 4 to 6 for application of soft soldering pastes for power modules, die-attach, chip-on-board, system-in-package (SiP), wafer bumping, in particular on UBMs (under-bump metallization) for SMT (surface mounted technology), in particular varnished circuits.

9. Use of a resin-free soldering paste in particular according to any one of the claims 4 to 6 for the assembly of electrical connections that are coated with polymers, in particular provided with a protective varnish, after soldering without after-treatment for removing residual flux.

10. Use of a resin-free soldering paste in particular according to any one of the claims 4 to 6 for the assembly of solder bumps on wafers, **characterised in that** the formation of pores is attained on less than 20% by volume of the bump volume by means of the resin-free soldering paste.

## Revendications

1. Gel stable au stockage contenant comme composants principaux un composant d'acide carboxylique, un composant d'amine et un composant de solvant, dans lequel le composant d'acide carboxylique est une substance facilement amovible de manière thermique d'un acide carboxylique ou d'un mélange d'acide carboxylique, le composant d'amine est une substance facilement amovible de manière thermique d'une amine tertiaire ou un mélange d'amines tertiaires, et le composant de solvant est un solvant polaire ou un mélange de solvants polaires, **caractérisé en ce que** le gel est exempt de résine.

2. Gel selon la revendication 1, **caractérisé en ce que** le composant de solvant présente des agents formateurs de pont hydrogène.

3. Procédé de fabrication d'un gel exempt de résine, **caractérisé en ce qu'**un composant d'acide carboxylique, un composant d'amine et un composant de solvant sont gélifiés les uns avec les autres, dans lequel le composant d'acide carboxylique est une substance facilement amovible de manière thermique d'un acide carboxylique ou d'un mélange d'acide carboxylique, le composant d'amine est une substance facilement amovible de manière thermique d'une amine tertiaire ou un mélange d'amines tertiaires, et le composant de solvant est un solvant polaire ou un mélange de solvants polaires.

4. Procédé de fabrication d'une pâte exempte de résine, **caractérisé en ce qu'**un gel selon une des revendications 1 à 3 est dispersé avec une poudre de solides.

5. Pâte à souder, pour laquelle une poudre de brasage tendre est dispersée dans un gel, notamment un gel selon une des revendications 1 à 3, dans laquelle le gel présente essentiellement un composant d'acide carboxylique et un composant d'amine qui sont gélifiés dans un solvant polaire, **caractérisée en ce que** la pâte à souder est exempte de résine.

6. Pâte à souder selon la revendication 5, **caractérisée en ce que** la pâte à souder présente du colorant, notamment moins de 1 ‰ en poids.

7. Procédé de brasage de composants et de métallisation subséquente, **caractérisé en ce qu'**une pâte à souder exempte de résine est refondue pour la fixation d'un composant et le composant est ensuite métallisé sans nettoyage supplémentaire des faces de métallisation avec des substances tensioactives ou basiques.

8. Utilisation d'une pâte à souder exempte de résine selon une des revendications 4 à 6 pour l'application de pâtes de brasage tendre pour des modules d'alimentation, connexion de la puce, montage direct des puces, système en boîtier (SiP), Wafer-Bumping, notamment sur des UBM (métallisation des supports de billes) ou SMT (technique du montage en surface), notamment des circuits vernis.

9. Utilisation d'une pâte à souder exempte de résine notamment selon une des revendications 4 à 6 pour la construction de connexions électriques qui sont enduites de polymères après le brasage sans traitement postérieur pour l'élimination de résidus de décapant, notamment pourvues d'un vernis protecteur.

10. Utilisation d'une pâte à souder exempte de résine notamment selon une des revendications 4 à 6 pour la construction de cordons de soudure sur des tranches, **caractérisée en ce que** la réalisation de pores est obtenue à moins de 20 % en volume du volume de cordon avec la pâte à souder exempte de résine.
